# EUROPEAN PATENT APPLICATION

(11) **EP 1 065 714 A1**
(43) Date of publication of application: **03.01.2001**
(21) Application number: 99900664.6
(22) Date of filing: 22.01.1999
(51) Int. Cl.: H01L 21/768, H01L 21/312

(54) **METHOD OF FABRICATING SEMICONDUCTOR DEVICE**

(30) Priority: 22.01.1998 JP 1007398; 05.03.1998 JP 5302198; 24.09.1998 JP 26970198
(71) Applicant: Citizen Watch Co., Ltd., Tokyo 163-0428 (JP)
(72) Inventor: MIYAZAKI, Taichi, Citizen Watch Co., Ltd., Tokorozawa-shi, Saitama 359-8511 (JP)
(74) Representative: Prüfer, Lutz H., Dipl.-Phys.
(86) International application number: JP9900255
(87) International publication number: WO9938208

(57) **Abstract**

A method of fabricating a semiconductor device for forming interconnections formed on a semiconductor device in multiple layers above and below an organic interlayer insulation film (19) as an insulation film, wherein the organic interlayer insulation film (19) having its insulation resistance lowered on receiving damage by plasma by sputter etching to be performed to reduce a contact resistance between lower layer interconnections (13a, 13b) and upper layer interconnections (21a, 21b) is subjected to ashing or ashing and annealing to thereby remove a charged-up layer (19a), which is a surface layer subjected to the plasma damage, to increase an insulation resistance value, thereby preventing a leak current from flowing between the upper layer interconnections (21a, 21b).

## Description

### TECHNICAL FIELD

The present invention relates to a method of fabricating a semiconductor device, more specifically, to a method of fabricating a semiconductor device using an organic interlayer insulation film as an insulation film between interconnections.

### BACKGROUND TECHNOLOGY

In a semiconductor device in which an integrated circuit composed of a large number of active elements and passive elements is formed, interconnections in multiple layers such as interconnections for interconnecting internal circuits thereof and interconnections for connecting to external circuits (or devices) are provided. Some semiconductor devices use organic interlayer insulation films as insulation films for insulating between the interconnections.

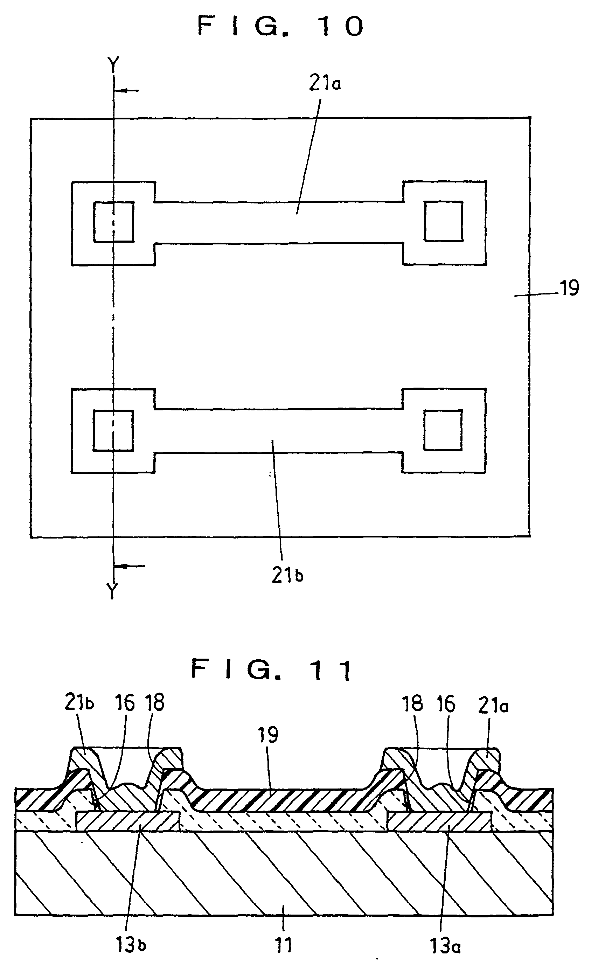

The structure of such a conventional semiconductor device and a fabricating method thereof will be explained with FIG. 10 and FIG. 11.

FIG. 10 is a schematic plane view of the semiconductor device and FIG. 11 is a somewhat enlarged schematic sectional view along the Y-Y line in FIG. 10.

Numeral 11 is a semiconductor substrate (a semiconductor chip or wafer) in which an integrated circuit is formed and a plurality of lower layer interconnections 13a, 13b formed by patterning a metal film containing aluminum as a major constituent are provided on the top face of the semiconductor substrate.

Moreover, a protection film 15 made of a silicon oxide film or a silicon nitride film is formed on the entire face of the semiconductor substrate 11, and contact holes 16 are provided at required positions in the protection film 15 on the lower layer interconnections 13a, 13b.

Furthermore, an organic interlayer insulation film 19 is formed on the entire face of the protection film 15, with contact holes 18 provided at the same positions as the contact holes 16 in the protection film 15. A photosensitive polyimide precursor, by way of example, is applied on the protection film 15 and thereafter patterned to form the contact holes 18 and then subjected to annealing to be polyimidized, thereby forming this organic interlayer insulation film 19.

Upper layer interconnections 21a, 21b formed by patterning a metal film containing aluminum as a major constituent are provided on the interlayer insulation film 19, and the upper layer interconnections 21a, 21b individually connect to the lower layer interconnections 13a, 13b through the contact holes 18, 18 respectively.

The upper layer interconnections 21a, 21b have the organic interlayer insulation film 19 exposed as illustrated therebetween to thereby be insulated.

It should be noted that before the upper layer interconnections 21a, 21b are formed, the surfaces of the lower layer interconnections 13a, 13b exposed at the bottom of the contact holes 18 are oxidized in the air to form oxide film insulation layers. Therefore, if the oxide film insulation layers are not removed, an excellent electrical connection characteristic is not demonstrated between the lower layer interconnections and the upper layer interconnections.

Accordingly, before the upper layer interconnections 21a, 21b are formed, the surfaces of the lower layer interconnections 13a, 13b exposed at the bottom of the contact holes 18 are cleaned by sputter etching with argon ions to remove the oxide film insulation layers.

As described above, the multiple layer interconnections can be easily installed on the semiconductor substrate 11 constituting the semiconductor device. Incidentally, only one pair of the lower layer interconnections 13a, 13b and one pair of the upper layer interconnections 21a, 21b are provided in FIG. 10 and FIG. 11, which is a simplified illustration for convenience of description, and in reality many lower layer interconnections and upper layer interconnections are provided. Regarding the upper layer interconnections, there are not only the ones which interconnect between circuits in the semiconductor device but also the ones which connect to external circuits (or devices).

However, the measured insulation resistance value between the upper layer interconnections 21a and 21b which are adjacent to each other in this example, is 10⁷ Ω to 10¹⁰ Ω. This is not a sufficiently high value as a value of the insulation resistance between interconnections in the semiconductor device. Such a low insulation resistance value between the upper layer interconnections causes an increase leak in current and an increase in power consumption in the semiconductor device.

Further, when the semiconductor device is packaged, there also arises a problem that the insulation resistance of the package is lowered to deteriorate reliability.

### DISCLOSURE OF THE INVENTION

An object of the present invention is to solve the above-described problems in a semiconductor device using an organic interlayer insulation film as an insulation film between interconnections to increase an insulation resistance between upper layer interconnections to thereby fabricate a reliable semiconductor device.

Therefore, a method of fabricating a semiconductor device according to the present invention is a method of fabricating a semiconductor device in which interconnections in a plurality of layers are formed on a semiconductor substrate, in which an integrated circuit is formed, with an organic interlayer insulation film as an insulation film, and has the following steps:
forming lower layer interconnections made of a metal film on the semiconductor substrate;
forming the organic interlayer insulation film on the semiconductor substrate on which the lower layer interconnections are formed;
forming contact holes at required positions on the lower layer interconnections by patterning the organic interlayer insulation film;
cleaning the surfaces of the lower layer interconnections exposed within the contact holes by sputter etching;
forming upper layer interconnections made of a metal film on the organic interlayer insulation film and connecting to the lower layer interconnections through the contact holes; and
recovering the organic interlayer insulation film having its insulation resistance lowered on receiving damage by plasma in the step of cleaning the surface of the lower layer interconnections from the damage by performing ashing a surface layer thereof;
and preferably, after the above step, the step of further recovering the organic interlayer insulation film from the damage by annealing is performed.

Alternatively, in the step of recovering the organic interlayer insulation film from the damage by performing ashing for the surface layer thereof, it is preferable that the ashing is performed while annealing is performed.

The ashing in the step of recovering from the damage can be performed using oxygen plasma or oxygen radicals, or using ozone which is produced by irradiating ultraviolet light to oxygen gas.

As described above, the method of fabricating the semiconductor device according to the present invention is characterized in that the organic interlayer insulation film having its insulation resistance lowered on receiving the damage by plasma by sputter etching to be performed to reduce the contact resistance between the lower layer interconnections and the upper layer interconnections is subjected to ashing to thereby recover from the plasma damage to increase the insulation resistance.

As a result of the experiment by the inventor, after the upper layer interconnections are formed on the organic interlayer insulation film, the insulation resistance value of the exposed surface of the organic interlayer insulation film results in 10⁷ Ω to 10¹⁰ Ω as described above. This fact means that the insulation resistance value has significantly lowered compared with 10¹⁴ Ω or more which is the insulation resistance value of the unprocessed organic interlayer insulation film.

It is found that the reason thereof is that the surface of the organic interlayer insulation film has received plasma damage by ion implantation of argon ions by sputter etching processing to be performed before the formation of the upper layer interconnections, whereby a charged-up layer is produced near the surface, resulting in a lowered insulation value of the organic interlayer insulation film.

For this reason, after the upper layer interconnections are formed on the organic interlayer insulation film as described above, the surface of the organic interlayer insulation film is subjected to ashing to thereby remove the surface layer (the charged-up layer) of the organic interlayer insulation film which has received plasma damage and recover the insulation resistance value of the organic interlayer insulation film, thereby increasing the insulation resistance value between the upper interconnections. Annealing is performed after the ashing or the ashing is performed while annealing is performed, thereby further increasing the insulation resistance value of the organic interlayer insulation film.

Thereby, it is possible to prevent a leak current between the interconnections and to reduce the power consumption of the semiconductor device.

### BRIEF DESCRIPTION OF DRAWINGS

FIG. 1 to FIG. 5 are views for explaining a method of fabricating a semiconductor device according to this invention and schematic sectional views showing respective steps, each corresponding to a section along the Y-Y line in FIG. 10.
FIG. 6 to FIG. 9 are schematic diagrams showing different examples of an apparatus for performing annealing and ashing for a surface layer of an organic interlayer insulation film in the method of fabricating the semiconductor device according to this invention.
FIG. 10 is a plane view of the semiconductor device which is an object of this invention.
FIG. 11 is a somewhat enlarged schematic sectional view along the Y-Y line in FIG. 10.

### BEST MODE FOR CARRYING OUT THE INVENTION

To explain this invention in more detail, preferred embodiments of the present invention will be explained with reference to the accompanying drawings.

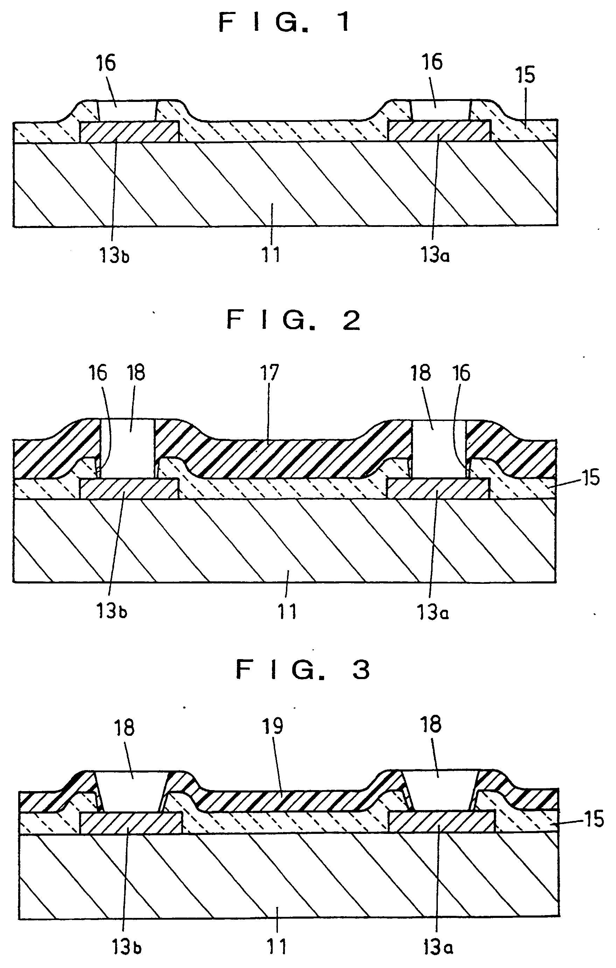

FIG. 1 to FIG. 5 are views for explaining a method of fabricating a semiconductor device according to this invention and schematic sectional views showing respective steps, each corresponding to a section along the Y-Y line in FIG. 10. Incidentally, a plane view of a complete semiconductor device is the same as FIG. 10, and thus FIG. 10 is used also for explanation of the embodiments of this invention.

In this embodiment, as shown in FIG. 1, a metal film containing aluminum as a major constituent is formed with a film thickness of 500 nm to 1000 nm on a semiconductor substrate (a semiconductor chip or wafer) 11 which is a main body of the semiconductor device by sputtering or vacuum evaporation. In this semiconductor substrate 11, an integrated circuit composed of a large number of active elements and passive elements constituting the semiconductor device is formed, though the illustration thereof is omitted.

Next, a photoresist (not shown) is applied on the metal film and thereafter subjected to exposure and development with a photomask in which an interconnection pattern is formed, so that the photoresist is patterned in a lower layer interconnection shape.

The aforesaid metal film is patterned by dry etching using an etching gas containing halogen base gas as a major constituent with the patterned photoresist as an etching mask. Thereby, lower layer interconnections 13a, 13b shown in FIG. 1 are formed.

Next, a protection film 15 made of a silicon oxide film or a silicon nitride film is formed with a film thickness of 800 nm to 1200 nm on the entire top face of the semiconductor substrate 11 including the lower layer interconnections 13a, 13b by a chemical vapor deposition process or the like.

A photoresist (not shown) is applied on the protection film 15 and thereafter subjected to exposure and development with a photomask in which openings are formed at required positions corresponding to the lower layer interconnections 13a, 13b, so that the photoresist is patterned.

Subsequently, the protection film 15 is patterned by dry etching using an etching gas containing carbon tetrafluoride gas as a major constituent with the patterned photoresist as an etching mask, thereby forming contact holes 16 shown in FIG. 1.

The contact holes 16 are formed by opening the protection film 15 to expose the lower layer interconnections 13a and 13b. The contact holes 16 become connecting portions for interconnections which are newly formed above the protection film 15 or to obtain electrical conduction between this semiconductor device and external devices. For instance, a bump, a metal wire, or the like is inserted into each contact hole 16, thereby obtaining electrical conduction between this semiconductor device and the external devices.

Next, as shown in FIG. 2, a photosensitive polyimide precursor 17 is applied with a film thickness of 20 µm to 4 µm on the protection film 15 by spin coating as an organic interlayer insulation film material. Thereafter, exposure and development are performed using a photomask in which opening portions are formed by patterning at positions corresponding to the contact holes 16.

Consequently, contact holes 18 are opened in the polyimide precursor 17 aligned with the contact holes 16 in the protection film 15.

The patterned polyimide precursor 17 is polyimidized by performing annealing for 30 minutes at a temperature of 350°C to 400°C in the air atmosphere or a nitrogen atmosphere using a high-temperature furnace.

The polyimide precursor 17 is reduced in film thickness to about half thereof by performing polyimidization, that is, reduced to 10 µm to 2 µm. This polyimidized film is an organic interlayer insulation film 19 in which the contact holes 18 are patterned as shown in FIG. 3.

The contact holes 18 in the organic interlayer insulation film 19 are formed to exist inside the contact holes 16, whereby the volume shrinks during the annealing at a temperature of 350°C to 400°C for performing polyimidization and the shape of the inner walls of the contact holes 18 comes to a normal tapered shape as shown in FIG. 3, resulting in an improved covering property of the upper layer interconnections which will be formed in the following step.

While the step of forming the organic interlayer insulation film 19 is performed, the surfaces of the lower layer interconnections 13a, 13b exposed at the bottom of the contact holes 18 as shown in FIG. 3 are oxidized in the air, resulting in the formation of oxide film insulation layers. Therefore, if the oxide film insulation layers are not removed, an excellent electrical connecting characteristic is not demonstrated between the lower layer interconnections 13a, 13b and the upper layer interconnections which will be formed on the lower layer interconnections 13a, 13b.

Accordingly, in order to remove the oxide film insulation layers, the surfaces of the lower layer interconnections 13a, 13b exposed at the bottom of the contact holes 18 are cleaned by sputter etching with argon ions.

Thereafter, a metal film containing aluminum as a major constituent, a metal film composed of a metal film containing aluminum as a major constituent and a metal film made of chrome, a metal film composed of a metal film containing aluminum as a major constituent and a metal film made of a metal having a high melting point, or a copper film is formed by sputtering or vacuum evaporation.

Further, a photoresist is applied on the metal film and thereafter subjected to exposure and development using a photomask in which an upper layer interconnection pattern is formed, so that the photoresist is patterned.

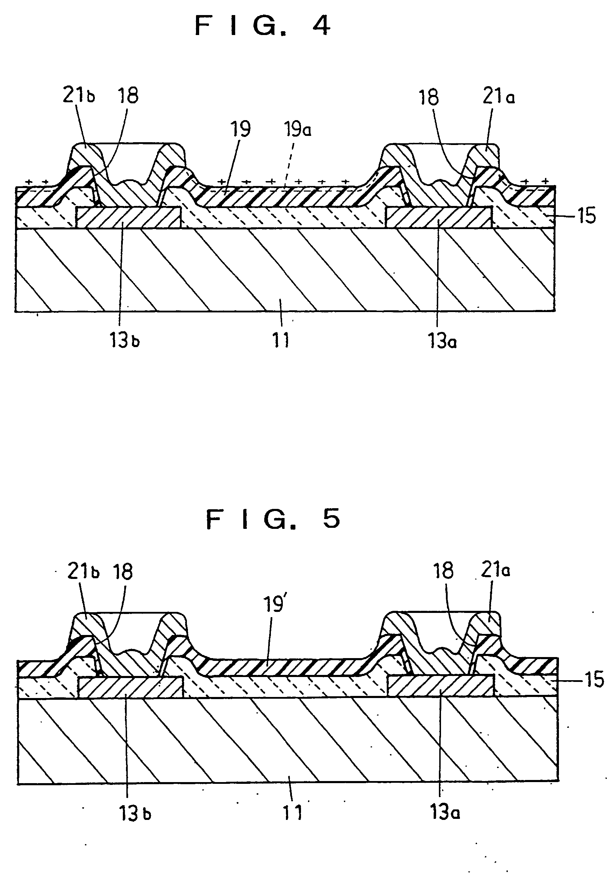

Then, the metal film is patterned by dry etching using halogen base gas as a major constituent or wet etching using phosphoric acid as a major constituent with the patterned photoresist as an etching mask, thereby forming upper layer interconnections 21a, 21b on the organic interlayer insulation film 19 as shown in FIG. 4 and FIG. 10.

The upper layer interconnections 21a, 21b are formed to fill the contact holes 18, 18 respectively, and thus they individually connect to the lower layer interconnections 13a, 13b. Moreover, the organic interlayer insulation film 19 is provided between the upper layer interconnections 21a, 21b, thereby electrically insulating them from each other.

However, as described above, before the upper layer interconnections 21a, 21b are formed, sputter etching with argon ions is performed to thereby carry out the step of cleaning which removes the oxide film insulation layers formed on the surfaces, which are exposed within the contact holes 18, of the lower layer interconnections 13a and 13b. In this step, the surface of the organic interlayer insulation film 19 receives plasma damage by ion implantation of argon ions, whereby a charged-up layer 19a is produced near the surface shown by a broken line in FIG. 4, resulting in a lowered insulation resistance value of the organic interlayer insulation film 19. Therefore, the resistance value between the upper layer interconnections 21a, 21b is in the 10⁷ Ω to 10⁹ Ω range.

Accordingly, after the upper layer interconnections 21a, 21b are formed on the organic interlayer insulation film 19, the surface of the organic interlayer insulation film 19 is subjected to ashing to thereby remove the surface layer (the charged-up layer 19a) of the organic interlayer insulation film which has received the plasma damage so as to recover the insulation resistance value of the organic interlayer insulation film 19, thereby increasing the insulation resistance value between the upper layer interconnections 21a, 21b. As a result, the resistance value between the upper layer interconnections 21a, 21b after the performance of the ashing is in the 10¹¹ Ω to 10¹³ Ω range.

FIG. 5 shows the semiconductor device after the ashing and numeral 19' shows the organic interlayer insulation film after the ashing. The insulation resistance value of the organic interlayer insulation film 19' can be further increased by performing annealing after the ashing or performing the ashing while annealing is performed. Thereby, it is possible to prevent a leak current between the upper layer interconnections 21a, 21b to thereby reduce the power consumption of the semiconductor device.

It should be noted that the protection film 15 is formed between the semiconductor substrate 11 and the organic interlayer insulation film 19 (19') in this embodiment, but this is not necessary, and it is suitable to omit the protection film 15 and to form the organic interlayer insulation film 19 directly on the semiconductor substrate 11.

As the ashing of the organic interlayer insulation film 19, there are, an ashing method performed by reactive ion etching between parallel plate electrodes using oxygen gas, a plasma etching method of performing ashing only with self bias of oxygen plasma, asking with only radicals of oxygen (neutralization active oxygen) which is activated by a radio-frequency power supply, an ashing method performed by ozone which is produced by irradiating ultraviolet light to oxygen gas, and so on.

For example, when performing the reactive ion etching between the parallel plate electrodes, ashing is performed for one minute at a radio-frequency (RF) output power of 400W while the oxygen pressure in the apparatus is kept at 5 Pa (pascal). Thereby, the surface layer of the organic interlayer insulation film 19 shown in FIG. 4 is etched by about 100 nm to about 150 nm, thereby removing the charged-up layer 19a. The resistance value between the upper layer interconnections 21a, 21b after the performance of such an ashing is in the 10¹¹ Ω to 10¹³ Ω range.

However, the organic interlayer insulation film 19 demonstrates an insulation resistance value of 10¹⁴ Ω or more when it is formed, which means that by ashing alone the organic interlayer insulation film 19 has not been completely recovered from the plasma damage.

This is because the surface of the organic interlayer insulation film 19' after the ashing shown in FIG. 5 is slightly electrically charged due to oxygen ions and activated species of oxygen, during the ashing.

Therefore, it is suitable to perform annealing following the ashing. As a method of the annealing, there is a method which uses a high-temperature furnace, a reflow furnace, or an oxidation furnace which is used in the semiconductor fabrication process.

When a polyimide material is used as the organic interlayer insulation film, annealing is performed at a temperature from 100°C to 400°C. However, if the organic interlayer insulation film does not deteriorate, the beat temperature may be 400°C or more.

The organic interlayer insulation film 19' of which the insulation resistance value has recovered to 10¹¹ Ω to 10¹³ Ω by the ashing is subjected to annealing for 30 minutes at an annealing temperature of 300°C at one atmospheric pressure in the air atmosphere using a high-temperature furnace, whereby the insulation resistance value of the organic interlayer insulation film 19' became 10¹⁴ Ω or more. In other words, the value became equal to the insulation resistance value right after the formation of the organic interlayer insulation film 19.

Incidentally, when the annealing is performed, it is necessary that air, nitrogen, argon, helium, hydrogen, or other gases exist at a gas pressure of 10⁻³ torr or more in the apparatus for performing the annealing.

In the experiment by the inventor, gas such as air, nitrogen, argon, helium, hydrogen, or the like were introduced into a vacuum apparatus and the pressure in the apparatus was brought to less than 10⁻³ torr and annealing was performed for 30 minutes at an annealing temperature of 350°C, but it was impossible to recover the insulation resistance value of the organic interlayer insulation film 19' to 10¹⁴ Ω or more.

This is because it is necessary that gas for carrying the electrical charge exists at the surface of the organic interlayer insulation film 19' in order for the electrical charge of the surface of the organic interlayer insulting film 19' excited by heat energy to dissipate.

Accordingly, when the pressure in the apparatus for performing the annealing is less than 10⁻³ torr, that is a vacuum, a probability of collision between the gas for carrying electrical charge and the organic interlayer insulation film 19' is low, and thus the insulation resistance value does not recover sufficiently.

On the other hand, as a result of performing annealing under the condition that a temperature of 220°C or more was maintained for 10 seconds with a maximum temperature of 230°C achieved in the air atmosphere and a nitrogen atmosphere with a oxygen concentration of 20 ppm or less using a reflow furnace, the insulation resistance value of the organic interlayer insulation film 19' which had been 10¹¹ Ω to 10¹³ Ω by the ashing could be brought to 10¹¹ Ω or more.

The same effect can be obtained even if the annealing is performed simultaneously with the asking, thereby performing the annealing and ashing.

For instance, in the case where reactive ion etching is performed between the parallel plate electrodes, ashing is performed for one minute while the semiconductor device is heated at a temperature of 100°C, the radio-frequency is set at 400 W, and the oxygen pressure in the apparatus is kept at 5 Pa (pascal), resulting in an insulation value of 10¹⁴ Ω or more between the upper layer interconnections 21a and 21b shown in FIG. 5.

The annealing and ashing is performed as described above, and the surface layer constituting the charged-up layer 19a of the organic interlayer insulation film 19 shown in FIG. 4 is removed by the ashing so that the organic insulation film 19 which is not electrically charged is exposed to the surface and simultaneously oxygen plasma and activated species of oxygen adhering to the surface of the organic insulation film 19 due to the ashing leave the surface of the organic insulation film 19 by heat energy. Therefore, it is possible to prevent the surface of the organic interlayer insulation film 19' after the ashing shown in FIG. 5 from being electrically charged.

For instance, as a result of performing the annealing and ashing for the organic interlayer insulation film 19 which had received plasma damage for five minutes at a temperature of 100°C at a vacuum degree of 0.8 torr using a coaxial type barrel asher, the surface layer of the organic interlayer insulation film 19 was removed by about 100 nm in thickness, whereby the insulation resistance value between the upper layer interconnections 21a, 21b recovered to 10¹⁴ Ω or more.

The annealing and ashing has an effect at a temperature of 50°C or more, and thus it is preferable to perform the processing in a temperature range of 50°C to 400°C when a polyimide material is used for the organic interlayer insulation film. However, the heat temperature may be 400°C or more if the organic material does not deteriorate;

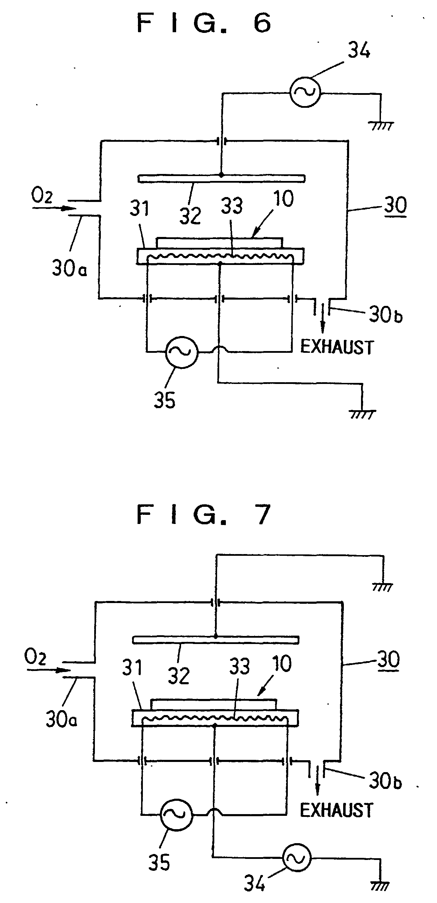

Here, examples of an apparatus for performing the annealing and ashing of the surface layer of the organic interlayer insulation film 19 in the semiconductor device and an annealing and ashing method thereof will be described with FIG. 6 to FIG. 9.

FIG. 6 and FIG. 7 show examples of the apparatus for performing the annealing and ashing by producing oxygen plasma between the parallel plate electrodes.

In a chamber (a vacuum container) 30, a lower electrode plate 31 and an upper electrode plate 32 in a parallel plate form are placed facing each other, and a semiconductor wafer 10 on which many semiconductor devices shown in FIG. 4 are formed is mounted on the lower electrode plate 31. In the apparatus shown in FIG. 6, radiofrequency power from a radio-frequency (RF) power supply 34 is applied to the upper electrode plate 32, and the lower electrode plate 31 is grounded. In the apparatus shown in FIG. 7, radiofrequency power from the radio-frequency (RF) power supply 34 is applied to the lower electrode plate 31, and the upper electrode plate 32 is grounded.

Moreover, a heater 33 is placed inside or under the lower electrode plate 31 covered with an insulation material and energized by the heater 35 to produce heat, thereby heating the semiconductor wafer 10 which is an object to be processed via the lower electrode plate 31.

Oxygen (O₂) is introduced from an inlet port 30a into the chamber 30, and exhausted from an exhaust port 30b. Then, oxygen plasma composed of oxygen radicals and oxygen ions is produced between the lower electrode plate 31 and the upper electrode plate 32 to collide the oxygen radicals and the oxygen ions against the surface of the organic interlayer insulation film which is formed on the semiconductor wafer 10 heated by the beater 33 by the self-bias thereof, thereby performing the annealing and ashing.

In the case of the apparatus shown in FIG. 6, the ashing is performed almost by oxygen radicals and there are few oxygen ions which reach the wafer 10 and act on the ashing. In the case of the apparatus shown in FIG. 7, the ashing is performed by both oxygen radicals and oxygen ions.

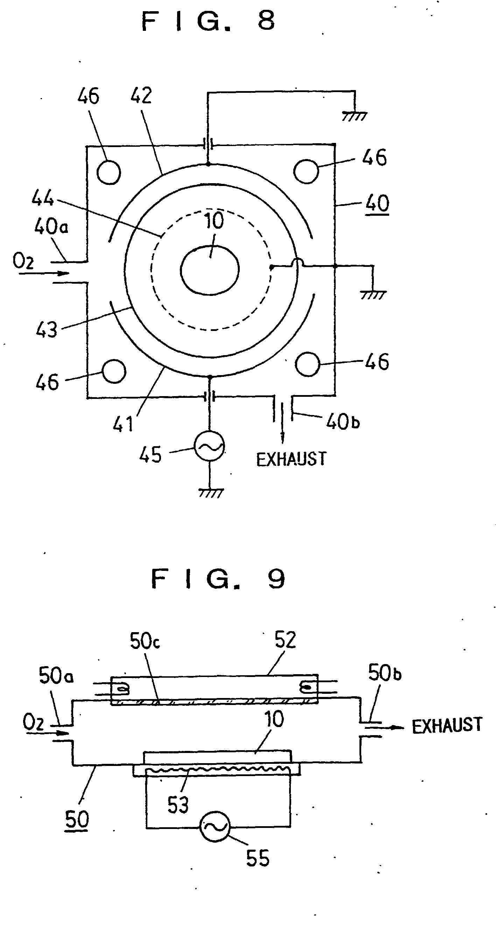

FIG. 8 shows an example of an apparatus for performing the annealing and ashing using a coaxial barrel asher. In this apparatus, semi-cylindrical electrodes 41, 42 composed of a pair of semi-cylindrical metal pieces, a quartz tube 43 which is slightly smaller in diameter than the electrodes 41 and 42, and a metal mesh cylinder 44 which is further smaller in diameter than the quartz tube 43 are coaxially placed in a chamber (a vacuum container) 40 in a prism shape, and the semiconductor wafer 10 which is an object to be processed is placed while supported by a supporting member not shown in the metal mesh cylinder 44. The metal mesh cylinder 44 is grounded via the chamber 40 made of metal.

Infrared lamps are respectively provided near four corners of the chamber 40 along a coaxial direction, and the inside of the quartz tube 43 is heated by turning on the four infrared lamps.

When oxygen is introduced from an inlet port 40a of the chamber 40, the oxygen enters the inside from one end of the quartz tube 43, passes through the inside, goes out from the other end, and is exhausted from an exhaust port 40b.

At that time, when radiofrequency power at about 400W is applied between the semi-cylindrical electrodes 41 and 42 by a radio-frequency power supply 45, plasma by oxygen is generated in the quartz tube 43, whereby oxygen radicals and oxygen ions are produced. Out of those, the oxygen ions are trapped by the metal mesh cylinder 44 which is grounded and vanish not to enter the inside, and only the oxygen radicals pass through the metal mesh cylinder 44 to reach the semiconductor wafer 10 and perform the ashing for the organic interlayer insulation film formed on the top face of the semiconductor wafer 10.

At this time, since the inside of the quartz tube 43 is heated by infrared irradiation by infrared lamps 46, ashing and annealing for the organic interlayer insulation film on the semiconductor wafer 10 are simultaneously performed. In this case, since the ashing for the organic interlayer insulation film is performed only by the oxygen radicals, there is no danger that ions remain on the surface of the organic interlayer insulation film after the processing, which is preferable.

FIG. 9 shows an example of an apparatus for performing ashing by producing ozone.

This apparatus comprises: a metal tube 50 which is provided with an inlet port 50a and an exhaust port 50b at both of its end portions and an elongated window 50c made of quartz at the top portion of its peripheral face; an ultraviolet lamp 52 provided adhering to the outside of the window 50c; a heater 53 attached to the outer peripheral face of the metal tube 50, with insulation therebetween, on the opposite side to the ultraviolet lamp 52; and a heater power supply 55 for energizing the heater 53.

A semiconductor wafer 10 which is an object to be processed is placed on an inner face of the metal tube 50 corresponding to a position at which the heater 53 is attached, and oxygen is introduced from the inlet port 50a into the metal tube 50 and exhausted from the exhaust port 50b.

At that time, the heater 53 is energized by the heater power supply 55 to produce heat, thereby heating the inside of the metal tube 50. Especially, the semiconductor wafer 10 which is placed near the heater 53 is heated.

Moreover, the ultraviolet lamp 52 is supplied with a current by a power supply not shown to emit light, thereby irradiating ultraviolet light. The ultraviolet light is irradiated into the inside of the metal tube through the window 50c, thereby producing ozone O₃ from oxygen O₂. The ozone collides against the organic interlayer insulation film on the heated semiconductor wafer 10 to thereby perform the ashing for the surface layer of the organic interlayer insulation film.

The annealing and ashing is performed by these apparatuses to recover the organic interlayer insulation film on the semiconductor wafer 10 from plasma damage, thereby increasing the insulation resistance value of the organic interlayer insulation film to 10¹⁴ Ω or more which is the initial value. Thereafter the semiconductor wafer 10 is cut into individual chips by dice cutting to make a plurality of semiconductor devices into a chip form.

Alternatively, it is possible that semiconductor devices in a chip form are placed side by side and subjected to ashing and the annelaing or the annealing and ashing.

### INDUSTRIAL APPLICABILITY

As has been described, according to the present invention, in the semiconductor device in which the interconnections are formed in multiple layers above and below the organic interlayer insulation film as the insulation film, the organic interlayer insulation film having its insulation resistance lowered on receiving the damage by plasma by sputter etching to be performed to reduce the contact resistance between the lower layer interconnections and the upper layer interconnections is subjected to ashing to thereby recover from the plasma damage to increase the insulation resistance value between the upper layer interconnections, thereby preventing a leak current between the interconnections and reducing the power consumption of the semiconductor device, resulting in a reliable semiconductor device.

## Claims

1. A method of fabricating a semiconductor device in which interconnections in a plurality of layers are formed on a semiconductor substrate, in which an integrated circuit is formed, with an organic interlayer insulation film as an insulation film; said method comprising the steps of:
forming lower layer interconnections made of a metal film on the semiconductor substrate;
forming the organic interlayer insulation film on the semiconductor substrate on which the lower layer interconnection are formed;
forming contact holes at required positions on the lower layer interconnections by patterning the organic interlayer insulation film;
cleaning the surfaces of the lower layer interconnections exposed within the contact holes by sputter etching;
forming upper layer interconnections made of a metal film on the organic interlayer insulation film and connecting to the lower layer interconnections through the contact holes; and
recovering the organic interlayer insulation film having its insulation resistance lowered on receiving damage by plasma in said step of cleaning the surfaces of the lower layer interconnections from the damage by performing ashing for a surface layer thereof.

2. The method of fabricating the semiconductor device according to claim 1,
wherein after said step of recovering the organic interlayer insulation film from the damage by performing asking for the surface layer thereof, the step of further recovering the organic interlayer insulation film from the damage by annealing is performed.

3. The method of fabricating the semiconductor device according to claim 1,
wherein in said step of recovering the organic interlayer insulation film from the damage by performing ashing for the surface layer thereof, the ashing is performed while annealing is performed.

4. The method of fabricating the semiconductor device according to claim 1, wherein the ashing is performed using oxygen plasma.

5. The method of fabricating the semiconductor device according to claim 2, wherein the ashing is performed using oxygen plasma.

6. The method of fabricating the semiconductor device according to claim 3, wherein the ashing is performed using oxygen plasma.

7. The method of fabricating the semiconductor device according to claim 1, wherein the ashing is performed using radicals of oxygen.

8. The method of fabricating the semiconductor device according to claim 2, wherein the ashing is performed using radicals of oxygen.

9. The method of fabricating the semiconductor device according to claim 3, wherein the ashing is performed using radicals of oxygen.

10. The method of fabricating the semiconductor device according to claim 1, wherein the ashing is performed using ozone which is produced by irradiating ultraviolet light to oxygen gas.

11. The method of fabricating the semiconductor device according to claim 2, wherein the ashing is performed using ozone which is produced by irradiating ultraviolet light to oxygen gas.

12. The method of fabricating the semiconductor device according to claim 3, wherein the ashing is performed using ozone which is produced by irradiating ultraviolet light to oxygen gas.
